# EUROPÄISCHE PATENTSCHRIFT

(11) **EP 1 401 636 B1**
(45) Veröffentlichungstag und Bekanntmachung des Hinweises auf die Patenterteilung: **10.01.2007**
(21) Anmeldenummer: 02750821.7
(22) Anmeldetag: 03.07.2002
(51) Int. Cl.: B30B 15/06, B32B 37/26

(54) **TRENNBLECH BZW. VERFAHREN ZUR HERSTELLUNG EINES TRENNBLECHES FÜR EIN MULTILAYERPRESSPAKET**
PARTITION PLATE AND METHOD FOR PRODUCING A PARTITION PLATE FOR A MULTI-LAYER PRESSED STACK
TOLE DE SEPARATION OU PROCEDE DE FABRICATION D'UNE TOLE DE SEPARATION DESTINEE A UN PAQUET DE PRESSE MULTICOUCHE

(30) Priorität: 04.07.2001 DE 10131887
(43) Veröffentlichungstag der Anmeldung: 31.03.2004
(73) Patentinhaber: Backhaus, Monika, 79350 Sexau (DE)
(72) Erfinder: Backhaus, Dieter, 79350 Sexau (DE)
(74) Vertreter: Hübsch, Dirk
(86) Internationale Anmeldenummer: PCT/DE2002/002418
(87) Internationale Veröffentlichungsnummer: WO 2003/004717

(56) Entgegenhaltungen:
- US-A- 6 130 000

## Beschreibung

Die Erfindung betrifft ein Trennblech für die Herstellung eines oder mehrerer Multilayer bzw. eines Mulilayerpreßpaketes nach dem Patentanspruch 1. Weiterhin betrifft die Erfindung ein Verfahren zur Herstellung eines Multilayerpreßpaketes gemäß den Patentansprüche 15 und ein Multilayerpreßpaket gemäß dem Patentanspruch 16.

Im Stand der Technik sind unterschiedlich ausgebildete Trennbleche für die Herstellung eines Multilayerpreßpaketes bzw. verschiedene Verfahren zur Herstellung eines Multilayerpreßpaketes, also für die Verpressung von mehrlagigen Leiterplatten bekannt. Die Verpressung der Multilayer (Leiterplatten) erfolgt im allgemeinen in Etagen- oder Vakuumpressen, wobei hier bei einer Temperatur von ca. 180° C die einzelnen Schichten der Multilayer miteinander entsprechend verpresst werden.

Im allgemeinen wird hierzu vorher zunächst ein Preßpaketaufbau innerhalb einer entsprechenden Presse realisiert. Hierbei werden zwischen zwei Pressenplatten, den entsprechenden Preßwerkzeugen sowie Preßpolstern mehrere Multilayer übereinandergelegt, die durch entsprechende Trennbleche bzw. Pressbleche voneinander getrennt sind. Jeder einzelne Multilayer ist - üblicherweise mehrlagig aufgebaut, nämlich weist mehrere durch eine jeweilige LaminatSchicht getrennte Prepreg-Schichten auf. Zwischen den einzelnen Laminat-Schichten bzw. Prepreg-Schichten sind entsprechende Kupferfolien zur Realisierung entsprechender Leiterbahnen vorgesehen. (Die einzelnen Schichten können auch als "Lagen" bezeichnet werden)

Bei der Herstellung der Multilayer selbst existieren nun unterschiedlich problematische Bereiche. Einerseits kann es aufgrund der thermischen Ausdehnung der Trennbleche auch zu einer ungünstigen Verschiebuag/Bewegung der einzelnen Schichten des Multilayers, also der Prepreg- bzw. der Laminat-Schichten und/oder auch der dazwischen angeordneten Kupferfolien kommen. Andererseits ist auch von Bedeutung, daß mit Hilfe der Trennbleche der Druck innerhalb des Multilayerpreßpaketes auch gleichmäßig auf die einzelnen Prepreg- bzw. Laminat-Schichten des Multilayerpreßpaketes übertragen werden muß, damit ein optimaler Verbund eines Multilayers hergestellt werden kann und ein Verrutschen der einzelnen Schichten soweit wie möglich verhindert ist.

Gemäß der DE 38 44 498 A1 soll ein Verzug miteinander verpressten Multilayer und auch eine unebene Kupferoberfläche dadurch vermieden werden, daß das Verpressen durch Vakuumanwendung und isostatische Presstechnik erfolgt. Hierbei werden zusätzliche Platten, schwimmend gelagert und thermisch isoliert, die bei der Erwärmung des Multilayerpreßpaketes die Pressplatten kühl halten. Nachteilig ist, daß bei der Erwärmung austretendes Epoxydharz die Kanten der Mulitlayer verkleben kann.

Gemäß der DE 35 07 568 C2 soll ein Verrutschen der Prepreg-Schichten durch eine Rutschsicherung vermieden werden, was einen möglichen Austritt der Prepregs an den Paketseiten jedoch nur dann verhindern kann, wenn die Kupferfolien etwas größer als die anderen Lagen gewählt werden, so daß das Prepreg daran ablaufen kann. Allerdings benötigt dieses Verfahren eine längere Erwärmungszeit und auch die Wärmedurchdringung ist wesentlich ungleichmäßiger, als wenn bspw. bei Aluminiumbleche als Trennbleche verwendet werden.

Gemäß der DE 41 16 543 A1 wird ein Trennblech aus Edelstahl verwendet, das einem bestimmten Wärmeausdehnungskoeffizienten aufweist, der nämlich dem Ausdehnungskoeffizienten des Kupfers angenähert ist. Hierdurch wird zwar eine Oberflächenspannung weitestgehend vermieden, die Erwärmungszeit für dieses Edelstahlblech ist jedoch entsprechend hoch.

So ist man in der Vergangenheit dazu übergegangen, als Trennbleche vorwiegend Aluminiumbleche bestimmter Legierung zu verwenden, die die Wärme besser und gleichmäßiger leiten können. Bei allen oben genannten Verfahren muß die Kupferfolie und das entsprechende Trennblech mit den anderen Schichten in einen hierfür vorgesehenen Legeraum durch speziell geschultes Personal von Hand (manuell) zu einem Multilayerpreßpaket zusammengefügt werden. U.a. ist hierbei problematisch, daß die oft sehr dünnen und daher empfindlichen Kupferfolien dabei schnell zerdrückt werden.

Die oben beschriebenen verwendeten Trennbleche bzw. Verfahren zur Herstellung von Multilayerpreßpaketen sind für die nächste Generation von Leiterplatten (Multilayer), insbesondere für die UMTS-Technologie noch nicht optimal. Die Leiterbahnen werden immer schmaler und gleichzeitig wird auf kleiner werdender Fläche immer mehr unterzubringen sein, insbesondere mit Hilfe der "HDI-High Density Interconnect-Technologie". Da einerseits die zu verwendende Kupferfolie hier immer dünner wird, wobei hier bereits Dicken von < 12 µm oder auch 5 µm genannt werden, erhöht sich zusätzlich damit auch die Gefahr, daß beim Verpreascn von Multilayern die Leiterbahnen der Innenlagen sich durch die äußeren Kupferfolien durchdrücken können. Bei diesem sich einstellenden Effekt spricht man vom sogenannten "Imagetransfer". Problematisch hierbei ist ein ungleichmäßiger Dickenabtrag beim Ätzen und entsprechende Ungenauigkeiten beim Bohren. Insbesondere diese extrem dünnen äußeren Kupferfolien können nicht mehr manuell verlegt werden. Sie müssen also vzw. als Verbund mit einem Trenn- oder Pressblech, so wie in der DE 198 31 461 C1 beschrieben, hergestellt werden.

So wird in der DE 198 31 461 C1 ein Verfahren zur partiellen Verbindung von Kupferfolien beliebiger Art und Dicke mit einem Aluminium-Preßblech (Trennblech) beliebiger Legierung und Dicke beschrieben, bei dem ein Verbund aus Aluminium-Pressblech und Kupferfolien hergestellt wird, wobei dieser Verbund zur Herstellung entsprechender Multilayerpreßpakete verwendet wird. Problematisch ist allerdings, daß ein Trenn- oder Pressblech aus Aluminium bzw. einer entsprechenden Aluminiumlegierung in der Härte, wie sie zur Vermeidung des oben genannten "Imagetransfer" erforderlich ist, eben nicht herstellbar ist. Die bisher eingesetzten Aluminiumlegierungen für das genannte Aluminium-Pressblech weisen derzeit eine Festigkeit von Rm 400 MPa auf. Das Verpressen der Multilayer erfolgt bei einer Temperatur von ca. 180 ° C über eine Dauer von ca. 90 Minuten. Bei dieser Temperatur sinkt die Festigkeit des Aluminium. Pressbleches auf ca. Rm 360 MPa ab. Folglich ist für die nächste Generation von Leiterplatten die Verwendung der bisher bekannten Trennbleche problematisch.

Weiterhin ist im Stand der Technik die Herstellung eines Multilayerpreßpaketes bekannt (US-PS 6,130,000), bei dem als Trennbleche ein "Carbon Steel" eingesetzt wird. Aber auch die Herstellung dieser Multilayerpreßpakete ist hier noch nicht optimal bzw. mit entsprechend hohen Kosten verbunden.

Der Erfindung liegt daher die Aufgabe zugrunde, ausgehend von den oben erwähnten Trennblechen bzw. dem oben erwähnten Verfahren, ein Trennblech für die Herstellung eines Multilayers bzw. ein Multilayerpreßpaket derart auszugestalten und weiterzubilden, dass der sogenannte "Imagetransfer" auf kostengünstige Weise vermieden ist.

Die zuvor aufgezeigte Aufgabe wird gemäß dem Merkmalen des Patentanspruches 1 gelöst. Mit Hilfe eines derartigen Trennbleches ist ein entsprechendes Multilayerpreßpaket gemäß dem Anspruch 15 bzw. 16 herstellbar.

Der Erfindung liegt der Grundgedanke zugrunde, dass Multilayer bzw. Multilayerpreßpakete hergestellt bzw. realisiert werden mit Hilfe eines Trennbleches, dass bestimmte mechanische Eigenschaften aufweist. Das erfindungsgemäße Trennblech ist als Stahlblech, nicht aber als Edelstahlblech ausgeführt und weist zumindest eine Zugfestigkeit von Rm ≥ 500 MPa und/oder eine Dehngrenze von mindestens Rp_{0,2} ≥ 470 MPa auf und zwar bei einer Temperatur von im wesentlichen 180° C. Bei der bevorzugten Ausführungsform der Erfindung weist das Stahlblech zusätzlich eine organische Beschichtung auf, wobei die organische Beschichtung als Gleitmittel aufgetragen und auf einer Olefin-Basis hergestellt ist.

Das Prinzip der Erfindung geht dahin, bei der Herstellung von Multilayer bzw. eines Multilayerpreßpaketes eben keine Aluminium-Preßbleche bzw. eben auch keine Edelstahlbleche zu verwenden, sondern Stahlbleche, die mindestens eine Dicke von 0,3 mm, vzw. eine Dicke von 0,4 mm aufweisen, also zusätzlich nochmal aufgrund der angegebenen mechanischen Festigkeitswerte "dünner" ausgebildet wenden können, als die bisher im Stand der Technik verwendeten Trennbleche mit einer Dicke von ca. 0,5 mm. So ist es bspw. bei der Herstellung dieser als Stahlbleche ausgeführten Trennbleche, insbesondere beim Kaltwalzen erforderlich, daß hier bereits auf beste Oberflächenbeschaffenheit geachtet wird, insbesondere die entsprechenden Stahlbleche riss. und porenfrei hergestellt werden. Zusätzlich wird aufgrund der Absenkung der Dicke des Stahlbleches auf "nur 0,4 mm" (oder darunter) die Bestückung einer Presse, nämlich mit der entsprechenden Anzahl von Multilayern pro Paket entsprechend erhöht. Es kann nämlich nunmehr pro Bestückung/Pressenöffnung, wobei die Beschichtung bisher grundsätzlich 14 Multilayer aufwies und daher 16 Trennbleche benötigte, bei einer entsprechenden Absenkung der Dicke der erfindungsgemäßen Trennbleche von 0,5 auf 0,4 mm eine Raumersparnis von 1,6 mm verwirklicht werden. Damit ist zusätzlich Platz für einen zusätzlichen weiteren Multilayer im Multilayerpereßpaket geschaffen, so daß sich die Anzahl der Multilayer im Presspaket auf 15 erhöht. Bei einer weiteren Absenkung der Stahlblech-Dicke, bspw. auf 0,3 mm, läßt sich eine entsprechend größere Raumersparnis erzielen. Dies spart bei der Herstellung der Multilayer entsprechende Kosten, da in einem Arbeitsgang nun eine größere Anzahl von Multilayern hergestellt werden kann wodurch die Arbeits- und Energiekosten verringert sind.

Es gibt nun eine Vielzahl von Möglichkeiten, das erfindungsgemäße Trennblech bzw. das Verfahren zur Herstellung des Multilayerpreßaketes mit Hilfe des genannten Trennbleches in vorteilhafter Art und Weise auszugestalten und weiterzubilden. Hierfür darf zunächst auf die dem Patentanspruch 1 nachgeordneten Patentansprüche sowie auf die Patentansprüche 15 und 16 verwiesen werden. Im folgenden sollen nun mehrere Ausführungsbeispiele für das erfindungsgemäße Trennblech bzw. für das erfindungsgemäße Verfahren anhand der folgenden Beschreibung und der nachfolgenden Zeichnung näher erläutert werden. In den Zeichnungen zeigt:
- Fig. 1: in einer schematischen vereinfachten Darstellung von der Seite den Aufbau eines Multilayerpreßpaketes zur Herstellung der entsprechenden Multilayer (Leiterplatten).
- Fig. 2: in vereinfachter schematischer Darstellung von der Seite eine erste Ausführungsform für das erfindungsgemäße Trennblech einschließlich einer Tabelle der bevorzugten Werte für die gewünschten mechanischen Festigkeitswerte bzw. die gewünschten Bereiche und
- Fig.3: eine zweite Ausführungsform, nämlich ein oberflächenbehandeltes Trennblech in vereinfachter schematischer Darstellung von der Seite.

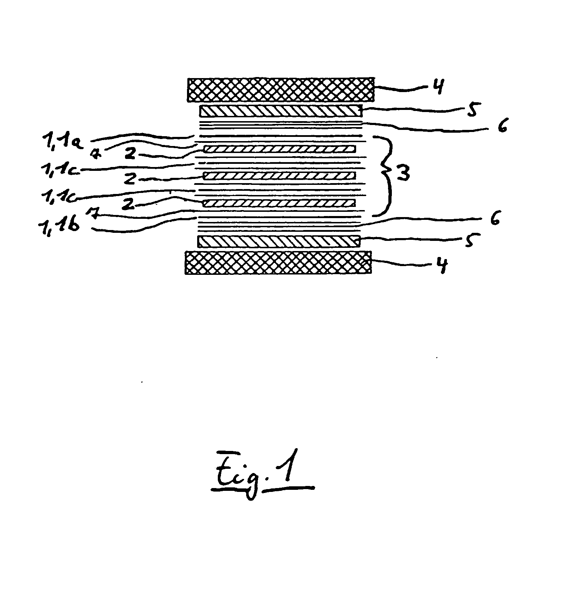

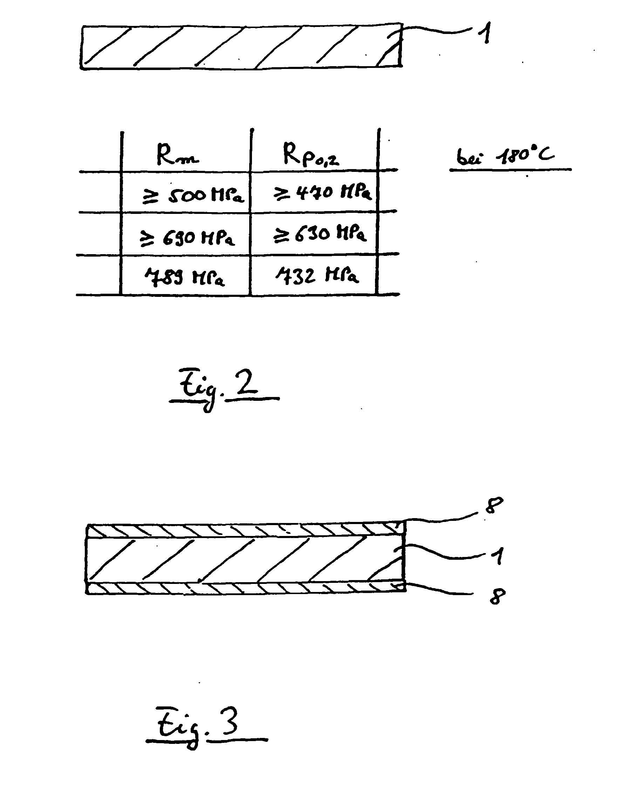

Die Fig.1 zeigt in schematischer Darstellung den Aufbau eines Multilayerpreßpaketes 3 mit mehreren Trennblechen 1 und Multlilayern 2. Fig. 2 zeigt ein Trennblech 1 mit einer entsprechenden Tabelle mit den gewünschten bzw. bevorzugten mechanischen Festigkeitswerten, wobei schließlich Fig. 3 ein oberflächenbehandeltes Trennblech 1 zeigt. Die Erfindung beschäftigt sich mit Trennblechen 1, die beim Laminieren von Mehrlagenleiterplatten-Presspaketen vorgesehen werden.

In Fig. 1 ist in schematischer Darstellung ein Multilayerpreßpaket 3 dargestellt. Wie ersichtlich, ist das Multilayerpreßpaket 3 in einer entsprechenden Presse, die hier nicht im einzelnen dargestellt ist, nämlich zwischen den Pressenplatten 4 und den Preßwerkzeugen 5 der Presse angeordnet. Damit eine optimale Anordnung des Multilayerpreßpaketes 3 möglich ist, sind hier zwischen den äußeren Trennblechen 1a und 1b des Multilayerpreßpaketes 3 noch zusätzliche Preßpolster 6 vorgesehen. Das Multilayerpreßpaket 3 besteht nun aus mehreren Multilayern 2 und mehreren Trennblechen 1, nämlich ein äußeres oberes Trennblech 1a, ein äußeres unteres Trennblech 1b und mehreren mittleren Trennblechen 1c. Zwischen den einzelnen Trennblechen 1 sind entsprechend die Multilayer 2 angeordnet, die den üblichen Aufbau aufweisen, der hier aber nicht im einzelnen darstellt ist. Die Multilayer 2 weisen entsprechende mehrlagige Schichten, nämlich entsprechende Prepreg-Schichten bzw. Laminat-Schichten sowie eine entsprechende Anzahl von hier nicht im einzelnen dargestellten Kupferfolien zur Realisierung der entsprechenden Leiterbahnen auf. Dies alles ist im einzelnen bekannt und soll hier nicht näher ausgeführt werden.

Zusätzlich ist aber in Fig. 1 noch erkennbar, daß zwischen den Multilayern 2 und den Trennblechen 1 entsprechende Trennfolien, nämlich Kupferfolien 7 vorgesehen sind. Vzw. werden die Trennbleche 1 und die Kupferfolien 7 als ein Verbund hergestellt, was im folgenden noch erläutert werden soll. Es ist auch möglich, derartige Kupferfolien 7 zu ersetzen, wobei ein Trennblech 1 mit einer Antihaftbeschichtung versehen wird.

Bei der Verpressung der Multilayer 2, also der einzelnen Schichten/Lagen des in Fig. 1 dargestellten jeweiligen Multilayers zu einem entsprechenden Verbund, herrscht innerhalb der Presse vzw. eine Temperatur von ca. 180° C. Die Trennbleche 1 gewährleisten während des Pressvorganges einerseits eine gleichmäßige Wärmeverteilung innerhalb des Multilayerpreßpaketes 3, gewährleisten andererseits eine gleichmäßige Druckverteilung. Ansonsten-würde es innerhalb des Multilayerpreßpaketes 3 zu einer ungleichmäßigen Wärme- und Druckverteilung kommen, so daß einige Bereiche der Multilayer 2 früher zu fließen beginnen würden, als andere, was zu Lufteinschlüssen, einer Dickenverteilung außerhalb der geforderten Toleranzen etc. führen würde und - im Endeffekt - im Querschnitt der einzelnen Multilayer 2 zu einer unterschiedlichen Kupferverteilung in übereinanderliegenden Lagen eines einzelnen Multilayers 2 und zu einer nicht ausreichenden Lamination im Bereich kupferarmer Stellen führen würde. Im Endeffekt ist die Ausbildung/Ausführung der Trennbleche 1 daher von entscheidender Bedeutung, um optimale Multilayer 2 herzustellen, insbesondere mögliche Oberflächendefekte eines Multilayers 2 einerseits zu vermeiden, andererseits zu verhindern, daß sich derartige Oberflächendefekte auf cinen anliegenden benachbarten Multilayer 2 innerhalb der Multilayerpreßpaktes 3 abdrücken würden. Hierfür sind allerdings die bisher im Stand der Technik verwendeten Trennbleche noch nicht optimal ausgebildet.

Das Trennblech 1 ist als ein Stahlblech, nicht jedoch als Edelstahlblech ausgeführt wobei das Stahlblech - bei einer Temperatur von im wesentlichen 180 °C - eine Zugfestigkeit von mindestens Rm ≥ 500 MPa und/oder - bei einer Temperatur von im wesentlichen 180° C - eine Dehngrenze von mindestens Rp_{0.2} ≥ 470 MPa aufweist. Anders ausgedrückt, bei dem Verfahren zur Herstellung des Trennbleches 1 für ein Multilayerpreßpaket 3, wird das Trennblech 1 aus einem Stahlblech hergestellt, wobei das Stahlblech bzw. dessen Legierung so ausgewählt wird, daß das Stahlblech - bei einer Temperatur von im wesentlichen 180° C - eine Zugfestigkeit von mindestens Rm ≥ 500 MPa und/oder - bei einer Temperatur von im wesentlichen 180° C - eine Dehngrenze von mindestens Rp_{0.2} ≥ 470 MPa aufweist.

Obwohl hier beide Alternativen genannt sind, also das Trennblech 1 bzw. die in den Fig. 1 bis 3 dargestellten Trennbleche 1 einerseits eine Zugfestigkeit von mindestens Rm ≥ 500 MPa oder eine Dehngrenze von mindestens Rp_{0,2} ≥ 470 MPa aufweisen können, ist jedoch die Kombination beider Festigkeitswerte, also die Realisierung einer Zugfestigkeit von mindestens Rm ≥ 500 MPa und die Realisierung einer Dehngrenze von mindestens Rp_{0,2} ≥ 470 MPa (jeweils bei einer Temperatur von ca. 180°C.) optimal. Es hat sich gezeigt, daß ein Trennblech 1, das als Stahlblech ausgeführt ist und genau diese Mindest-Festigkeitswerte aufweist, sich für die Herstellung der Multilayer 2 bzw. der Multilayerpreßpakete 3 optimal eignet. Der "Imagetransfer" wird mit Hilfe dieser Trennbleche 1 entsprechend vermieden, wobei die hergestellten Multilayer 2 eine optimale Oberfläche aufweisen und die erfindungsgemäßen Trennbleche 1 auch noch mehrfach verwendet werden können, was wiederum zu Einsparungen entsprechender Kosten führt.

Die Fig. 2 mit der dazugehörigen Tabelle zeigt ein Trennblech 1, das als Stahlblech ausgeführt ist. In der Tabelle sind entsprechende Festigkeitswerte für die Dehngrenze Rp_{0.2} sowie für die Zugfestigkeit Rm angegeben, aber jeweils für Temperaturen bei 180°C, also im wesentlichen für die Temperatur, die innerhalb eines Multilayerpreßpaketes 3 bei einer entsprechenden Verpressung der Multilayer 2 vorherrscht. Aus der Tabelle der Fig. 2 ist gut ersichtlich, daß die Mindestwerte für die Zugfestigkeit Rm ≥ 500 MPa und für die Dehngrenze Rp_{0.2} ≥ 470 MPa liegen. Allerdings hat sich herausgestellt, daß sich Multilayer 2 mit besonders guten Eigenschaften herstellen lassen und auch der Imagetransfer besonders gut verhindern läßt, wenn die Zugfestigkeit Rm ≥ 690 MPa und die Dehngrenze Rp_{0,2} ≥ 630 MPa ist. Bei der bevorzugten Ausführungsform eines erfindungsgemäßen Trennbleches 1 liegen die Festigkeitswerte Rm = 789 MPa und Rp_{0,2} = 732 MPa.

Während die Fig. 2 ein hier unbehandeltes, insbesondere oberflächenunbehandeltes Trennblech 1 aus Stahl zeigt, zeigt die Fig. 3 ein oberflächenbehandeltes bzw. oberflächenbearbeitetes, insbesondere beschichtetes Trennblech 1. Das in Fig. 3 gezeigte, als Stahlblech ausgeführte Trennblech 1 ist hier im wesentlichen oberflächenbehandelt, nämlich beidseitig beschichtet ausgeführt. Das in Fig. 3 gezeigte Trennblech 1, weist im wesentlichen auch die in der Tabelle in Fig. 2 aufgeführten mechanischen Festigkeitswerte bzw. Festigkeitsbereiche auf. Die Dicke des Trennbleches 1 liegt im Bereich von 0,3 bis 1 mm, vzw. weist das Trennblech 1 eine Dicke von 0,3 bis 0,5 mm, insbesondere aber eine Dicke von 0,4 mm auf. Die in Fig. 3 erkennbare zusätzliche Beschichtung 8 des Trennblaches 1 kann nun auf unterschiedliche Art und Weise realisiert sein, bspw. es kann sich hier um eine organische, um eine anorganische oder metallische Beschichtung 8 handeln. So kann als metallische Beschichtung 8 eine Plattierung aus Aluminium oder Kupfer hergestellt werden. Auch eine insbesondere galvanisch aufgetragene Beschichtung 8 aus Chrom ist denkbar. Die Dicken des Trennbleches 1 bzw. der Beschichtung 8 sind in Fig. 3 nur schematisch dargestellt. Zu den Dickenmaßen der Beschichtung 8 wird im folgenden noch näheres erläutert.

So kann als Beschichtung 8 eine Plattierung des Trennbleches 1 in Frage kommen, bspw. eine Plattierung mit Aluminium oder Kupfer, wobei diese zuletzt genannten Auflagemetalle verbesserte Wärmeleitfähigkeiten aufweisen und daher die Wärmeleitfähigkeit innerhalb eines Multilayerpreßpaketes 3 entsprechend nochmals verbessern können.

Es ist auch denkbar, daß die Beschichtung 8 als organische oder anorganische Beschichtung ausgeführt ist, bspw. auf das Trennblech 1 ein Gleitmittel aufgetragen wird. Vzw. kann das Gleitmittel auf Olefin-Basis hergestellt sein oder es wird eine andere organische Substanz, die ähnliche Eigenschaften besitzt, als Beschichtung 8 aufgetragen. Eine anorganische Beschichtung 8 könnte bspw. auch auf Kunststoffbasis realisiert werden. Während das als Stahlblech ausgeführte Trennblech 1 vzw. eine Dicke von 0,4 mm aufweist, sollte die Dicke der Beschichtung 8 mindestens 2µm betragen, vzw. im Bereich von 5 bis 25 µm, insbesondere bei einer metallischen Beschichtung 8 liegen. Mit Hilfe einer Beschichtung 8 sind noch optimalere Oberflächen von Multilayern 2 herstellbar, insbesondere werden auch Beschädigungen der entsprechenden Kupferfolien 7 weitestgehend vermieden.

Es ist nochmal wichtig zu erwähnen, daß als Stahlblech hier keine Edelstähle verwendet werden sollen. Zwar können auch unbehandelte Stahlbleche, also keine oberflächenbehandelten oder beschichteten Stahlbleche als Trennbleche 1 zur Herstellung entsprechender Multilayer 2 bzw, zur Herstellung entsprechender Multilayerpreßpakte 3 verwendet werden, dennoch sollte der Oberfläche der verwendeten Trennbleche 1 besondere Beachtung geschenkt werden, da insbesondere einwandfreie Oberflächen auch eine Beschädigung der Kupferfolien 7 oder Multilayern 2 vermeiden. Insbesondere zur Erzielung von glatteren Oberflächen kann das Stahlblech noch zusätzlich zu der Beschichtung 8 mit einem Gleitmittel versehen werden, es ist aber auch zusätzlich wichtig, daß beim Kaltwalzen auf beste Oberflächenbeschaffenheit der Stahlbleche geachtet wird, die Oberfläche also riss- und porenfrei hergestellt wird.

Der Einsatz der oben beschriebenen als Stahlbleche ausgeführte Trennbleche 1 hat sich als besonders vorteilhaft herausgestellt, wenn die als Stahlbleche ausgeführten Trennbleche 1 die entsprechenden oben angegebenen Festigkeitswerte aufweisen. Von besonderem Vorteil ist weiterhin die relativ geringe thermische Ausdehnung der als Stahlbleche ausgeführte Trennbleche 1, so daß hier Verschiebungen/Verrutschungen bzw. Bewegungen innerhalb der einzelnen Schichten/Lagen des Multilayers 2 während der Verpressung bzw. der entsprechend herrschenden Temperaturen von im wesentlichen 180° C vermieden werden können.

Vzw. wird das hier dargestellte Trennblech 1, im Verbund mit einer hier in den Fig. 2 und 3 nicht dargestellten Kupferfolie hergestellt, so wie bspw. in der DE 198 31 461 C1 ausführlich erläutert wird. Dies hat besonders den Vorteil, daß die sehr dünnen Kupferfolien, die teilweise manuell gar nicht mehr eingelegt werden können, zusammen mit dem Trennblech 1 schnell und ohne besonderen Arbeitsaufwand entsprechend in das Multilayerpreßpaket 3 miteingebracht werden können, um entsprechende Multilayer 2 herzustellen.

Zusätzlich darf nun noch auf folgendes hingewiesen werden: Im Stand der Technik werden vzw. Trennbleche mit einer Dicke von 0,5 mm bisher verwendet. Aufgrund der oben angegebenen Festigkeitswerte für die hier erfindungsgemäß verwendeten Trennbleche 1 kann die Dicke dieser Trennbleche 1 auf vzw. 0,4 mm, ja sogar bis zu 0,3 mm reduziert werden. Da bisher im Stand der Technik ein Multilayerpreßpaket 3, insgesamt (pro Pressenöffnung) 14 Multilayer 2 aufweisen kann (in Fig. 1 sind "nur" drei Mulitlayer 2 schematisch dargestellt) und hierzu dann 16 Trennbleche verwendet werden, kommt man bei einer Reduzierung der Dicke auf vzw. 0,4 mm zu einer Raumersparnis von insgesamt 1,6 mm (16 x (0,5 - 0,4 mm)), wenn man die erfindungsgemäßen Trennbleche 1 verwendet. Hierdurch wird in einem Multilayerpreßpaket 3 zusätzlicher Raum für einen weiteren zusätzlichen Multilayer 2 geschaffen, so daß die Gesamtanzahl der innerhalb eines Multilayerpreßpaktes 3 angeordneten Multilayer 2 von 14 Multilayern 2 auf 15 Multilayer 2 erhöhbar ist. Bei einer weiteren Reduzierung der Dicke auf 0,3 mm wird weiterer zusätzlicher Raum geschaffen. Hierdurch sind in der Produktion größere Kosten, insbesondere Arbeits- und Energiekosten, einsparbar.

Eines der bevorzugten erfindungsgemäßen Trennbleche 1 hat insbesondere die folgende Zusammensetzung: 0,04 Gewichts-% C, 0,01 Gewichts-% Si, 0,22 Gewichts-% Mn, 0,012 Gewichts-% P, 0,005 Gewichts-% S und 0,037 Gewichts-% Al; wobei die verbleibenden restlichen Gewichtsprozente der entsprechende Fe-Anteil ist. Die hier beschriebene Stahllegierung wird auch als "ST2 K70 RP" bezeichnet. Es sind auch andere Stahllegierungen, bspw. analog zu "C75" denkbar, die die entsprechenden mechanischen Festigkeitswerte aufweisen. Vzw. weisen die erfindungsgemäßen Trennbleche eine Länge von 660 mm und eine Breite von 580 mm auf.

Das erfindungsgemäße Trennblech 1 bzw. das erfindungsgemäße Stahlblech, das dann als Pressblech in den Verbund eines herzustellenden Multilayerprcßpakets 3 einlegbar ist, wird vzw. aus einem unlegierten Kohlenstoff-Stahl hergestellt, also nicht aus einem legierten Stahl. Erfindungsgemäße Trennbleche 1, die als unlegierte Stahlbleche ausgeführt sind, weisen im wesentlichen die folgenden Zusammensetzung auf: Zwischen 0,03 bis 1,2 Gewichts-% C- (Kohlenstoff) und 0,2 bis 1,5 Gewichts-% Mn- (Mangan) Anteile auf. Besonders bevorzugte Bereiche sind für den entsprechenden unlegierten Kohlenstoff-Stahl bzw. für das unlegierte Stahlblech 0,03 bis 0,1 Gewichts-% C und 0,2 bis 0,5 Gcwichts-% Mn. Die verbleibenden Gewichts-% bildet im wesentlichen der entsprechende Fe-Anteil. Hierbei kann der unlegierte Kohlenstoff-Stahl, also das erfindungsgemäße Stahlblech geringe Spuren von anderen Elementen, wie bspw. Phosphor, Schwefel, Aluminium und/oder Silizium aufweisen, die jedoch keinerlei Einfluß auf die Stahlqualität haben.

Insbesondere zur Vermeidung des eingangs beschriebenen Imagetransfers ist die erwähnte Dehngrenze Rp_{0.2} von entscheidender Bedeutung. Ist nämlich die Dehngrenze Rp_{0.2} zu gering, so unterliegen, insbesondere die im Stand der Technik verwendeten Trennbleche einer bleibenden Formveränderung, woraufhin nämlich der oben beschriebene Imagetransfer bei Wiederverwendung dieser Trennbleche dann auftritt. Für die gemäß der Erfindung beschriebenen Dehngrenzen von Rp_{0.2} ≥ 470 MPa hat sich gezeigt, dass dieser Imagetransfer hierdurch eben vermieden werden kann, da bei der Wiederverwendung der erfindungsgemäßen Trennbleche 1 gewährleistet ist, daß diese eben aufgrund der entsprechend ausgebildeten Dehngrenze keiner bleibenden Formveränderungen unterworfen sind, so dass diese mehrfach wiederverwendet werden können, ohne dass der Imagetransfer auftritt.

Als Gleitmittel wird vzw. ein auf Olefin-Basis hergestelltes Gleitmittel eingesetzt. Es kommen auch Polymere auf Poly-Olefin-Basis in Betracht bzw. Poly-Olefin-Emulsionen, bspw. aufgeschlämmte Poly-Olefin-/Wasserlösungen. Hierdurch bedingt wird ein guter Korrosionsschutz für die erfindungsgemäßen Trennbleche 1 gewährleistet und auch eine gute Antihaft-Beschichtung, insbesondere gegen Harze erzielt.

Vzw. weisen die erfindungsgemäßen Trennbleche 1 eine Wärmeleitfähigkeit von im wesentlichen 40 bis 60 W/mK auf und/oder einen thermischen Ausdehnungskoeffizienten von 9 bis 14 10⁻⁶ K⁻¹ auf.

Eine weitere bevorzugte Ausführungsform für das erfindungsgemäße Trennblech 1 hat folgende Zusammensetzung: 0,037 Gewichts-% C, 0,003 Gewichts-% Si, 0,21 Gewichts-% Mn, 0,008 Gewichts-% Phosphor, 0,01 Gewichts-% Schwefel, 0,039 Gewichts-% Aluminium und 0,020 Gewichts-% Chrom; wobei die verbleibenden restlichen Gewichts-% der entsprechende Fe-Anteil ist, und die Anteile von Phosphor, Schwefel, Aluminium, Chrom und Silizium hier als "Verunreinigungen" zu sehen sind. Die hier zuvor genannte Zusammensetzung wird vzw. grundsätzlich aus kaltgewalzten Bandstahl, ähnlich dem "DC04" hergestellt und weist im wesentlichen eine Wärmeleitfähigkeit von 57 W/mK und einen thermischen Ausdehnungskoeffizienten von 11,45 10⁻⁶K⁻¹ auf. Vzw. ist eine Beschichtung 8 für diese zuletzt genannte weitere Ausführungsform vorgesehen, die als Dünnschichtverchromung ausgeführt ist und eine Beschichtungsdicke von 70 bis 130 mg/m² aufweist.

Im Ergebnis werden durch das erfindungsgemäße Trennblech 1 bzw. durch das erfindungsgemäße Verfahren zur Herstellung des Trennbleches 1 entscheidende Vorteile erzielt und die im Stand der Technik bekannten Nachteile vermieden.

### Bezugszeichenliste:

- 1: Trennblech
- 1a: oberes Trennblech
- 1b: unteres Trennblech
- 1c: mittleres Trennblech
- 2: Multilayer
- 3: Multilayerpreßpaket
- 4: Pressenplatte
- 5: Preßwerkzeug
- 6: Preßpolster
- 7: Kupferfolie
- 8: Beschichtung

## Patentansprüche

1. Trennblech (1) für die Herstellung eines oder mehrer Multilayer (2) bzw. eines Multilayerpreßpaketes (3), wobei das Trennblech (1) in den Verbund eines herzustellenden Multilayerpreßpaketes (3) als Pressblech, insbesondere zwischen zwei Multilayern (2) einlegbar ist, wobei das Trennblech (1) als ein Stahlblech, nicht aber als Edelstahlblech ausgeführt ist, wobei das Stahlblech - bei einer Temperatur von 180° C - eine Zugfestigkeit von mindestens Rm ≥ 500 MPa und /oder - bei einer Temperatur von 180° C - eine Dehngrenze von mindestens Rp_{0.2} ≥ 470 MPa aufweist, wobei das Stahlblech zusätzlich eine organische Beschichtung (8) aufweist und die organische Beschichtung (8) als Gleitmittel aufgetragen und auf einer Olefin-Basis hergestellt ist.

2. Trennblech nach dem vorhergehenden Anspruch, **dadurch gekennzeichnet, daß** das Stahlblech oberflächenbehandelt ist.

3. Trennblech nach einem der vorhergehenden Ansprüche, **dadurch gekennzeichnet, daß** das Stahlblech eine Dicke von 0,3 bis 0,5 mm aufweist.

4. Trennblech nach einem der vorhergehenden Ansprüche, **dadurch gekennzeichnet, daß** das Stahlblech zusätzlich eine anorganische oder metallische Beschichtung aufweist.

5. Trennblech nach einem der vorhergehenden Ansprüche, **dadurch gekennzeichnet, daß** die metallische Beschichtung aus Aluminium oder Kupfer hergestellt ist.

6. Trennblech nach einem der vorhergehenden Ansprüche, **dadurch gekennzeichnet, daß** die Beschichtung (8) eine Dicke von mindestens 2 µm aufweist.

7. Trennblech nach einem der vorhergehenden Ansprüche, **dadurch gekennzeichnet, daß** zumindest eine Oberfläche des Stahlbleches mit einer Kupferfolie (7) bedeckt ist.

8. Trennblech nach einem der vorhergehenden Ansprüche, **dadurch gekennzeichnet, daß** das Stahlblech eine Zugfestigkeit von mindestens Rm ≥ 690 MPa und eine Dehngrenze von mindestens Rp_{0,2} ≥ 630 MPa aufweist.

9. Trennblech nach einem der vorhergehende Ansprüche, **dadurch gekennzeichnet, dass** das Stahlblech (1) aus einem unlegierten Kohlenstoff-Stahl besteht.

10. Trennblech nach einem der Ansprüche 1 bis 8, **dadurch gekennzeichnet, dass** das Stahlblech 0.03 bis 1,2 Gewichta-% C- und 0,2 bis 1,5 Gewichts-% Mn-Anteile aufweist.

11. Trennblech nach Anspruch 10, **dadurch gekennzeichnet, dass** das Stahlblech 0,03 bis 0,1 Gewichts-% C- und 0,2 bis 0,5 Gewichts-% Mn-Anteile aufweist.

12. Trennblech nach einem der Ansprüche 10 oder 11, **dadurch gekennzeichnet, dass** das Stahlblech geringe Spuren von Phosphor, Schwefel, Aluminium und/oder Silizium aufweist.

13. Trennblech nach einem der Ansprüche 9 bis 12, **dadurch gekennzeichnet, dass** das Gleitmittel ein Polymer auf einer Poly-Olefin-Basis ist.

14. Trennblech nach einem der Ansprüche 4 bis 13, **dadurch gekennzeichnet, dass** die Beschichtung als Dünnschichtverchromung ausgeführt ist.

15. Verfahren zur Herstellung eines Multilayerpreßpaketes (3), wobei ein Trennblech (1) in den Verbund eines herzustellenden Multilayerpreßpaketes (3) als Preßblech, insbesondere zwischen zwei Multilayer (2) eingelegt wird, **dadurch gekennzeichnet, daß** ein Trennblech (1) nach einem der Ansprüche 1 bis 14 zwischen zwei Multilayer (2) eingelegt wird.

16. Multilayerpreßpaket (3) **dadurch gekennzeichnet, dass** mindestens ein Trennblech (1) nach einem der Ansprüche 1 bis 14 innerhalb des Multilayerpreßpaketes (8) eingelegt ist.

## Claims

1. Separating sheet (1) for producing one or more multilayers (2) or a multilayer pressed stack (3), wherein the separating sheet (1) can be placed as a pressing sheet in the composite structure of a multilayer pressed stack (1) to be produced, in particular between two multilayers (2), wherein the separating sheet (1) is formed as a steel sheet, but not as a high-grade steel sheet, wherein the steel sheet has - at a temperature of 180°C - a tensile strength of at least Rm ≥ 500 MPa and/or - at a temperature of 180°C - a yield strength of at least Rp_{0.2} ≥ 470 MPa, wherein the steel sheet additionally has an organic coating (8) and the organic coating (8) is applied as a lubricant and is produced on an olefin basis.

2. Separating sheet according to the preceding claim, **characterized in that** the steel sheet is surface-treated.

3. Separating sheet according to one of the preceding claims, **characterized in that** the steel sheet has a thickness of from 0.3 to 0.5 mm.

4. Separating sheet according to one of the preceding claims, **characterized in that** the steel sheet additionally has an inorganic or metallic coating.

5. Separating sheet according to one of the preceding claims, **characterized in that** the metallic coating is produced from aluminium or copper.

6. Separating sheet according to one of the preceding claims, **characterized in that** the coating (8) has a thickness of at least 2 µm.

7. Separating sheet according to one of the preceding claims, **characterized in that** at least one surface of the steel sheet is covered with a copper foil (7).

8. Separating sheet according to one of the preceding claims, **characterized in that** the steel sheet has a tensile strength of at least Rm ≥ 690 MPa and a yield strength of at least Rp_{0.2} ≥ 630 MPa.

9. Separating sheet according to one of the preceding claims, **characterized in that** the steel sheet (1) consists of an unalloyed carbon steel.

10. Separating sheet according to one of Claims 1 to 8, **characterized in that** the steel sheet has 0.03 to 1.2% by weight C and 0.2 to 1.5% by weight Mn elements.

11. Separating sheet according to Claim 10,
**characterized in that** the steel sheet has 0.03 to 0.1% by weight C and 0.2 to 0.5% by weight Mn elements.

12. Separating sheet according to either of Claims 10 and 11, **characterized in that** the steel sheet has small traces of phosphorus, sulphur, aluminium and/or silicon.

13. Separating sheet according to one of Claims 9 to 12, **characterized in that** the lubricant is a polyolefin-based polymer.

14. Separating sheet according to one of Claims 4 to 13, **characterized in that** the coating is formed as a thin-layer chromium plating.

15. Method for producing a multilayer pressed stack (3), wherein a separating sheet (1) is placed as a pressing sheet in the composite structure of a multilayer pressed stack (3) to be produced, in particular between two multilayers (2), **characterized in that** a separating sheet (1) according to one of Claims 1 to 14 is placed between two multilayers (2).

16. Multilayer pressed stack (3), **characterized in that** at least one separating sheet (1) according to one of Claims 1 to 14 is placed within the multilayer pressed stack (3).

## Revendications

1. Tôle de séparation (1) destinée à réaliser une ou plusieurs multicouches (2) ou un paquet (3) de presse multicouches, la tôle de séparation (1) pouvant être insérée dans l'ensemble du paquet (3) de presse multicouches à réaliser sous la forme d'une tôle de presse, en particulier entre deux multicouches (2), la tôle de séparation (1) étant réalisée en tôle d'acier mais non en tôle d'acier allié, la tôle d'acier présentant à une température de 180°C une résistance en traction d'au moins Rₘ ≥ 500 MPa et/ou à une température de 180°C une limite d'allongement d'au moins Rp_{0,2} ≥ 470 MPa, la tôle d'acier présentant de plus un revêtement organique (8) et le revêtement organique (8) étant appliqué comme agent coulissant et préparé à base d'oléfine.

2. Tôle de séparation selon la revendication précédente, **caractérisée en ce que** la tôle d'acier est traitée en surface.

3. Tôle de séparation selon l'une des revendications précédentes, **caractérisée en ce que** la tôle d'acier présente une épaisseur de 0,3 à 0,5 mm.

4. Tôle de séparation selon l'une des revendications précédentes, **caractérisée en ce que** la tôle d'acier présente de plus un revêtement organique ou un revêtement métallique.

5. Tôle de séparation selon l'une des revendications précédentes, **caractérisée en ce que** le revêtement métallique est réalisé en aluminium ou en cuivre.

6. Tôle de séparation selon l'une des revendications précédentes, **caractérisée en ce que** le revêtement (8) a une épaisseur d'au moins 2 µm.

7. Tôle de séparation selon l'une des revendications précédentes, **caractérisée en ce qu'**au moins une surface de la tôle d'acier est recouverte d'un film de cuivre (7).

8. Tôle de séparation selon l'une des revendications précédentes, **caractérisée en ce que** la tôle d'acier présente une résistance en traction d'au moins Rₘ ≥ 690 MPa et une limite d'allongement d'au moins Rp_{0,2} ≥ 630 MPa.

9. Tôle de séparation selon l'une des revendications précédentes, **caractérisée en ce que** la tôle d'acier (1) est constituée d'un acier au carbone non allié.

10. Tôle de séparation selon l'une des revendications 1 à 8, **caractérisée en ce que** la tôle d'acier présente une teneur en C de 0,03 à 1,2 % en poids et une teneur en Mn de 0,2 à 1,5 % en poids.

11. Tôle de séparation selon la revendication 10, **caractérisée en ce que** la tôle d'acier présente une teneur en C de 0,03 à 0,1 % en poids et une teneur en Mn de 0,2 à 0,5 % en poids.

12. Tôle de séparation selon l'une des revendications 10 ou 11, **caractérisée en ce que** la tôle d'acier présente de petites traces de phosphore, de soufre, d'aluminium et/ou de silicium.

13. Tôle de séparation selon l'une des revendications 9 à 12, **caractérisée en ce que** l'agent coulissant est un polymère à base d'une polyoléfine.

14. Tôle de séparation selon l'une des revendications 4 à 13, **caractérisée en ce que** le revêtement est réalisé sous la forme d'un chromage en couche mince.

15. Procédé de préparation d'un paquet (3) de presse multicouches, dans lequel une tôle de séparation (1) est insérée dans l'ensemble d'un paquet (3) de presse multicouches à réaliser sous la forme d'une tôle de presse, et en particulier entre deux multicouches (2), **caractérisé en ce que** l'on insère entre deux multicouches (2) une tôle de séparation (1) selon l'une des revendications 1 à 14.

16. Paquet (3) de presse multicouches, **caractérisé en ce qu'**au moins une tôle de séparation (1) selon l'une des revendications 1 à 14 est insérée à l'intérieur du paquet (3) de presse multicouches.
